# EUROPEAN PATENT APPLICATION

(11) **EP 4 156 296 A1**
(43) Date of publication of application: **29.03.2023**
(21) Application number: 22197333.2
(22) Date of filing: 23.09.2022
(51) Int. Cl.: H01L 29/775, H01L 29/06, H01L 29/10, H01L 29/423, H01L 21/336, B82Y 10/00

(54) **ELIMINATION OF SUB-FIN LEAKAGE IN STACKED NANOSHEET ARCHITECTURES**

(30) Priority: 24.09.2021 US 202117485294
(71) Applicant: INTEL Corporation, Santa Clara, CA 95054 (US)
(72) Inventor: ATANASOV, Sarah, Beaverton, 97003 (US); RAMAMURTHY, Rahul, Hillsboro, 97123 (US); SUNG, Seung Hoon, Portland, 97229 (US)
(74) Representative: 2SPL Patentanwälte PartG mbB

(57) **Abstract**

Embodiments disclosed herein include semiconductor devices and methods of forming such semiconductor devices. In an embodiment, a semiconductor device comprises a sub-fin. In an embodiment, the sub-fin comprises a semiconductor material. In an embodiment, a channel is above the sub-fin, where the channel is physically detached from the sub-fin. In an embodiment a first layer is over the sub-fin, and a second layer is over the first layer. In an embodiment, the second layer is different than the first layer.

## Description

### TECHNICAL FIELD

Embodiments of the disclosure are in the field of semiconductor structures and processing and, in particular, to nanosheet transistors with reduced sub-fin leakage.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into the 10 nanometer node or sub-10 nanometer node range. Consequently, fabrication of the functional components needed for future technology nodes may require the introduction of new methodologies or the integration of new technologies in current fabrication processes or in place of current fabrication processes.

In the manufacture of integrated circuit devices, multi-gate transistors, such as tri-gate transistors and gate-all-around (GAA) transistors, have become more prevalent as device dimensions continue to scale down. Tri-gate transistors and GAA transistors are generally fabricated on either bulk silicon substrates or silicon-on-insulator substrates. In some instances, bulk silicon substrates are preferred due to their lower cost and compatibility with the existing high-yielding bulk silicon substrate infrastructure.

Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

### BRIEF DESCRIPTION OF THE DRAWINGS

Figures 1A-1F are cross-sectional illustrations of a process for forming a transistor device with reduced sub-fin leakage using a pair of insulating layers, in accordance with an embodiment.
Figures 2A-2E are cross-sectional illustrations of a process for forming a transistor device with reduced sub-fin leakage using a single insulating layer, in accordance with an embodiment.
Figures 3A-3E are cross-sectional illustrations of a process for forming a transistor device with reduced sub-fin leakage with a gate dielectric last approach, in accordance with an embodiment.
Figures 4A-4G are cross-sectional illustrations of a process for forming a transistor device with reduced sub-fin leakage using a self-assembled monolayer (SAM) approach, in accordance with an embodiment.
Figure 5 is a cross-sectional illustration of a gate-all-around (GAA) transistor device with insulating layers to reduce sub-fin leakage, in accordance with an embodiment.
Figure 6 is a cross-sectional illustration of a GAA transistor device with an insulating layer to reduce sub-fin leakage, in accordance with an embodiment.
Figure 7 illustrates a computing device in accordance with one implementation of an embodiment of the disclosure.
Figure 8 is an interposer implementing one or more embodiments of the disclosure.

### DESCRIPTION OF THE EMBODIMENTS

Embodiments described herein comprise nanosheet transistors with reduced sub-fin leakage. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

To provide context, gate-all-around (GAA) transistor devices include channel structures such as nanowires, nanoribbons, nanosheets, and the like. The gate stack surrounds an entire perimeter of the channel structure in order to provide gate control around the entire channel. Each GAA transistor device typically includes a stack of channel structures above a sub-fin. In the case of GAA transistor devices, one source of inefficiency is the presence of sub-fin leakage. That is, current from the channels can leak out of the transistor through the underlying sub-fin. In current approaches, sub-fin leakage is mitigated through heavy doping of the sub-fin region. However, even with high dopant concentrations, GAA transistor devices still suffer from sub-fin leakage.

Another benefit to embodiments disclosed herein is that there is better control of the channels. In a typical structure, the GAA channels are controlled on all four sides, but the bottom portion of the channel resembles a tri-gate structure. That is, there is gate control on only three sides of the channel. As such, the advantage of efficient gate control is hurt due to the bottom fin. In embodiments disclosed herein, the bottom portion is fully isolated, providing full gate-all-around architectures on the remaining channel regions.

Additionally, it is to be appreciated that the bottom fin portion does not require any doping. This helps with variation of transistors induced by random dopant fluctuation. As such, the transistors have improved uniformity, and electrical performance.

Accordingly, embodiments disclosed herein include architectures to further reduce and/or eliminate sub-fin leakage in GAA transistor devices. Instead of relying on heavy dopant concentrations, embodiments disclosed herein include one or more barrier layers that are insulating. As such, current is blocked from entering the sub-fin. Additionally, it is to be appreciated that methods disclosed herein include selective deposition processes in order to isolate the deposition of the insulating material to over the sub-fin instead of over the entire transistor device. That is, in some embodiments, the barrier layer (or layers) are provided over the sub-fin without the need for lithography or other patterning processes.

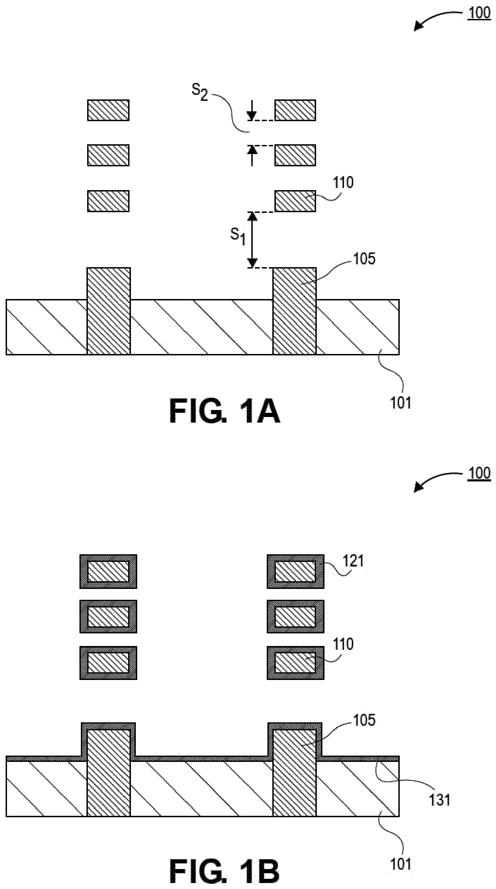

Referring now to Figures 1A-1F, a series of cross-sectional illustrations of a method for forming a GAA transistor device 100 with reduced sub-fin leakage is shown, in accordance with an embodiment. In an embodiment, the sub-fin leakage is mitigated through the use of a barrier layer stack. The barrier layer stack is fabricated using selective deposition processes.

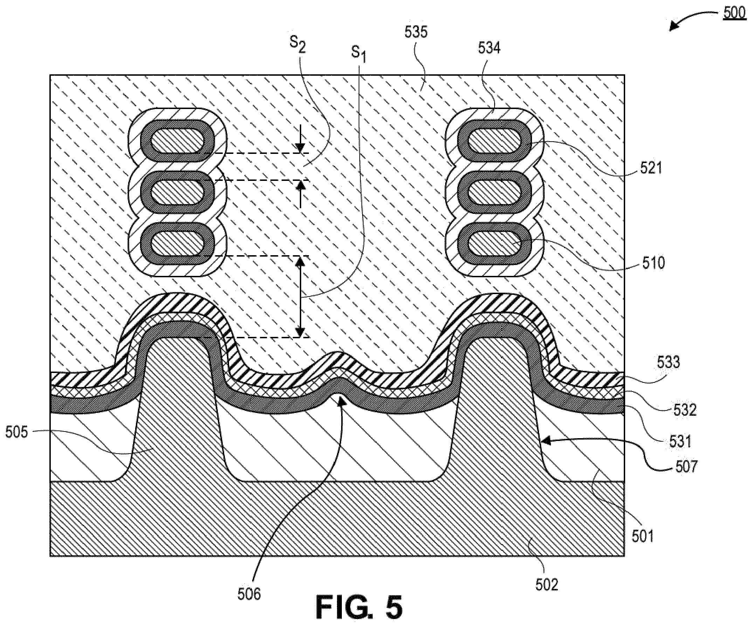

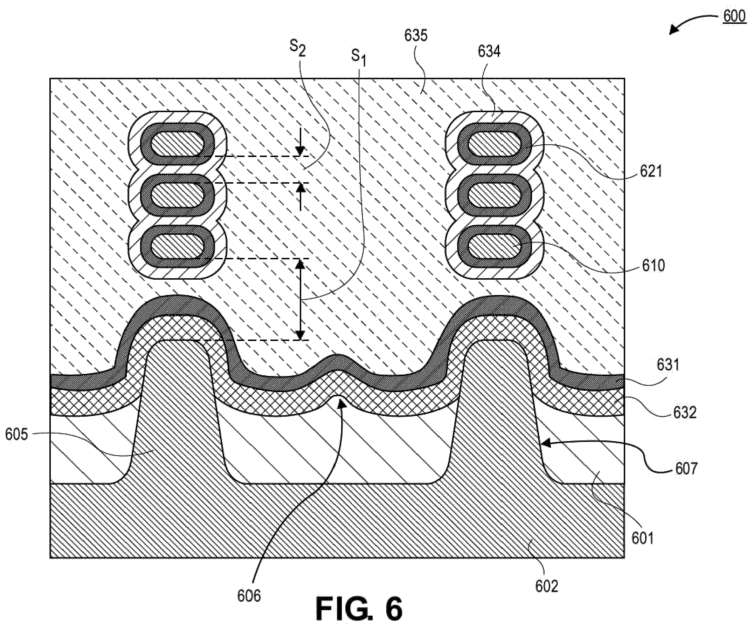

Referring now to Figure 1A, a cross-sectional illustration of a GAA transistor device 100 is shown, in accordance with an embodiment. As shown, sub-fins 105 may extend up through a substrate layer 101. The sub-fins 105 may comprise a semiconductor material, such as silicon or the like. In an embodiment, the sub-fins 105 may extend entirely through the substrate layer 101 and be coupled together by a base layer (not shown) below the substrate layer 101. An example with the underlying base layer is provided in Figures 5 and 6 below. In an embodiment, the substrate layer 101 may be an insulator. In some instances the substrate layer 101 may be referred to as a shallow trench isolation (STI) layer.

In an embodiment, the transistor device 100 may further comprise one or more channel regions 110 above the sub-fin 105. In the illustrated embodiment, three channel regions 110 are provided over each sub-fin 105. However, it is to be appreciated that any number of channel regions 110 (e.g., one or more) may be provided over each sub-fin 105. In an embodiment, the bottommost channel region 110 may be spaced away from the sub-fin 105 by a first spacing S₁. The channel regions 110 may be spaced away from each other by a second spacing S₂. The second spacing S₂ may be smaller than the first spacing S₁. The larger value of the first spacing S₁ may be used in order to accommodate barrier layers (deposited in subsequent processing operations) below the bottommost channel region 110. In an embodiment, the first spacing S₁ may be approximately 1.5 times the second spacing S₂ or more. In other embodiments, the first spacing S₁ may be approximately 2 times the second spacing S₂ or more. However, in other embodiments, the first spacing S₁ and the second spacing S₂ may be approximately the same. As used herein, "approximately" may refer to a value that is within 10% of the stated value. For example, approximately 2 times may refer to a value that is between 1.8 times and 2.2 times.

In an embodiment, the channel regions 110 comprise a semiconductor material. The semiconductor material of the channel regions 110 may be the same semiconductor material as the sub-fin 105. In other embodiments, the channel regions 110 and the sub-fin 105 may comprise different semiconductor materials. The channel regions 110 may be doped in some embodiments. In the illustrated embodiment, the channel regions 110 are illustrated as being nanosheets or nanoribbons. However, it is to be appreciated that similar transistor architectures with nanowire channel regions 110 may also be used in accordance with embodiments disclosed herein.

Referring now to Figure 1B, a cross-sectional illustration of the transistor device 100 after the deposition of a gate dielectric 121 is shown, in accordance with an embodiment. The gate dielectric 121 may be, for example, any suitable dielectric to electrically isolate the sub-fin region, such as silicon dioxide or high-k gate dielectric materials. In other embodiments, nitride materials may also be used for the high-k gate dielectric 121. Examples of high-k gate dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. Furthermore, it is to be appreciated that the gate dielectric 121 may include a combination of different materials. In some embodiments, an annealing process may be carried out on the gate dielectric 121 to improve its quality when a high-k material is used.

In an embodiment, the gate dielectric 121 may be deposited with any suitable deposition process. In a particular embodiment, the gate dielectric 121 is deposited with an atomic layer deposition (ALD) process. The ALD process is a conformal process. The conformal deposition allows for the gate dielectric 121 to surround an entire perimeter of the channel regions 110. Additionally, a first layer 131 may also be deposited over the exposed portions of the sub-fin 105 (i.e., top surfaces and sidewalls of the sub-fin 105) and the top surface of the substrate layer 101. The first layer 131 may comprise the same material composition as the gate dielectric 121 and have substantially the same thickness as the gate dielectric 121.

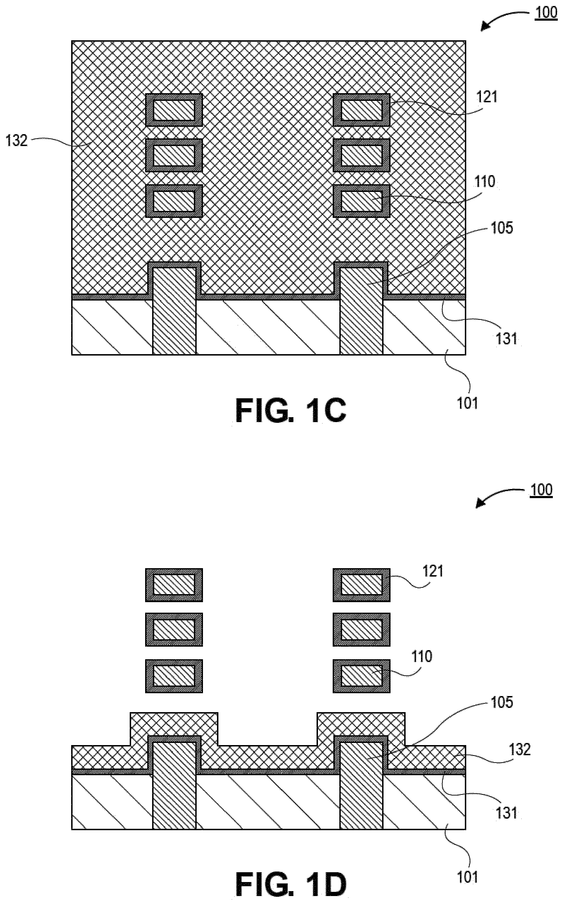

Referring now to Figure 1C, a cross-sectional illustration of transistor device 100 after a second layer 132 is disposed over the exposed surfaces is shown, in accordance with an embodiment. In an embodiment, the second layer 132 may be an insulating material. The second layer 132 may be a material that enables the selective deposition of a third layer (deposited in a subsequent operation). In a particular embodiment, the second layer 132 comprises silicon and oxygen (e.g., SiOx). In the illustrated embodiment, the second layer 132 is deposited to a thickness so that the channel regions 110 are covered. However, it is to be appreciated that in other embodiments, one or more channel regions 110 may be above the top surface of the second layer 132.

Referring now to Figure 1D, a cross-sectional illustration of the transistor device 100 after a recess of the second layer 132 is shown, in accordance with an embodiment. In an embodiment, the recessing of the second layer 132 may be implemented with a wet etching process. The wet etch may be a timed etching process in some embodiments. The recessing of the second layer 132 may result in a top surface of the second layer 132 being below the bottommost channel region 110.

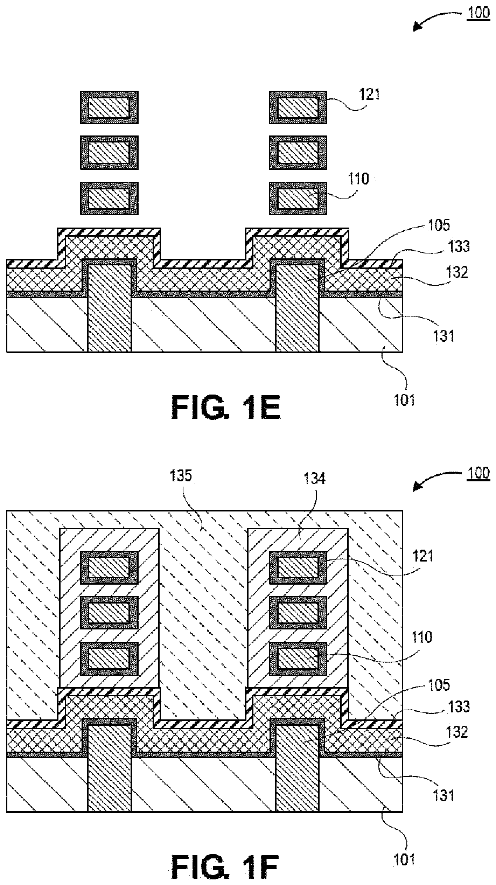

Referring now to Figure 1E, a cross-sectional illustration of the transistor device 100 after a third layer 133 is deposited is shown, in accordance with an embodiment. In an embodiment, the third layer 133 may be selectively deposited over the second layer 132. That is, the third layer 133 does not substantially deposit over the gate dielectric 121. In the case of the second layer 132 comprising silicon and oxygen, the third layer 133 may comprise silicon and nitrogen (e.g., SiNx). The selectivity of the deposition of the third layer 133 may be enhanced by implementing a plasma treatment process. For example, the plasma treatment may be an NH₃ plasma treatment of the surfaces before the deposition of the third layer 133. In an embodiment, the third layer 133 may be deposited with an ALD process. For example, a SiN third layer 133 may be deposited using SiI₄ and NH₃ source gases, though it is to be appreciated that other gasses may also be used.

It is to be appreciated that sub-fin leakage is significantly reduced or completely eliminated by the presence of insulating barrier layers (i.e., the second layer 132 and the third layer 133). The thicknesses of the barrier layers 132 and 133 can be controlled in order to increase the effect of reducing sub-fin leakage. That is, thicker barrier layers 132 and 133 may result in less sub-fin leakage. Alternatively, the material selection of the barrier layers 132 and 133 can be used to reduce sub-fin leakage. For example, materials with better leakage behavior (e.g., materials with higher dielectric constants) have reduced sub-fin leakage. As such, thinner barrier layers 132 and 133 may still provide the desired sub-fin leakage reduction, when proper materials are chosen. Additionally, it is to be appreciated that since the spacing between the top of the sub-fin 105 and the bottommost channel region 110 is increased, as described above, there is room for thicker barrier layers 132 and 133 without blocking the ability to provide gate control around the entire perimeter of the channel region 110.

Referring now to Figure 1F, a cross-sectional illustration of the transistor device 100 after completion of the gate stack is shown, in accordance with an embodiment. In an embodiment, the gate stack may comprise a workfunction metal 134 and a fill metal 135. When the workfunction metal 134 is an N-type workfunction metal, the workfunction metal 134 preferably has a workfunction that is between about 3.9 eV and about 4.2 eV. N-type materials that may be used to form the workfunction metal include, but are not limited to, hafnium, zirconium, titanium, tantalum, aluminum, and metal carbides that include these elements, i.e., titanium carbide, zirconium carbide, tantalum carbide, hafnium carbide and aluminum carbide. When the workfunction metal 134 will serve as a P-type workfunction metal, the workfunction metal 134 preferable has a workfunction that is between about 4.9 eV and about 5.2 eV. P-type materials that may be used to form the workfunction metal 134 include, but are not limited to, ruthenium, palladium, platinum, cobalt, nickel, and conductive metal oxides, e.g., ruthenium oxide. In an embodiment, the fill metal 135 may comprise a wide range of materials, such as polysilicon, silicon nitride, silicon carbide, or various suitable metals or metal alloys, such as aluminum (Al), tungsten (W), titanium (Ti), tantalum (Ta), copper (Cu), titanium nitride (TiN), or tantalum nitride (TaN), for example.

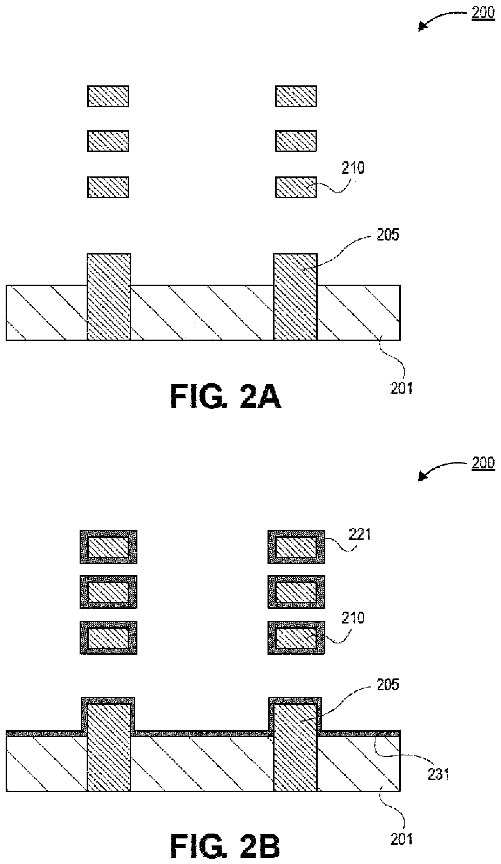

Referring now to Figures 2A-2E, a series of cross-sectional illustrations depicting a process for forming a transistor device 200 is shown, in accordance with an embodiment. The transistor device 200 in Figures 2A-2E may be similar to the transistor device 100 in Figures 1A-1F, with the exception of one of the barrier layers being omitted.

Referring now to Figure 2A, a cross-sectional illustration of a transistor device 200 is shown, in accordance with an embodiment. In an embodiment, the transistor device 200 in Figure 2A may be substantially similar to the transistor device 100 illustrated in Figure 1A. For example, sub-fins 205 extend up through a substrate layer 201. Additionally, one or more channel regions 210 may be disposed over a top surface of the sub-fins 205. A spacing between the bottommost channel region 210 and the sub-fin 205 may be larger than a spacing between the channel regions 210.

Referring now to Figure 2B, a cross-sectional illustration of the transistor device 200 after the deposition of a gate dielectric 221 around the channel regions 210 is shown, in accordance with an embodiment. In an embodiment, the gate dielectric 221 may be a high-k dielectric material. Suitable materials for the gated dielectric 221 are described in greater detail above, and will not be repeated here in the interest of brevity. Since the deposition of the gate dielectric 221 is a conformal process, a first layer 231 may also be deposited over the exposed portions of the sub-fin 205 and the substrate layer 201. The first layer 231 may be the same material as the gate dielectric 221 and have substantially the same thickness as the gate dielectric 221.

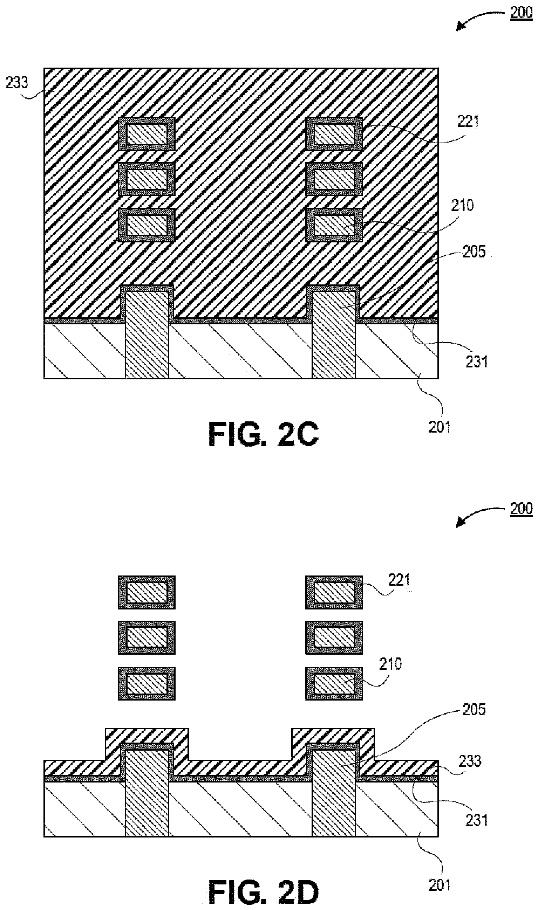

Referring now to Figure 2C, a cross-sectional illustration of the transistor device 200 after a second layer 233 is disposed over the exposed surfaces is shown, in accordance with an embodiment. In an embodiment, the second layer 233 may be an insulating material. In some embodiments, the second layer 233 may comprise silicon and oxygen (e.g., SiOx), or the second layer 233 may comprise silicon and nitrogen (e.g., SiNx). In an embodiment, the deposition of the second layer 233 may be a blanket deposition process. In an embodiment, the thickness of the second layer 233 may be sufficient to completely cover all of the channel regions 210. In other embodiments, the second layer 233 may be deposited to a thickness so that one or more of the channel regions 210 remain exposed.

Referring now to Figure 2D, a cross-sectional illustration of the transistor device 200 after the second layer 233 is recessed is shown, in accordance with an embodiment. In an embodiment, the second layer 233 may be recessed with a wet etching process. The wet etching process may be a timed etch in order to leave behind a portion of the second layer 233 with a desired thickness. In some embodiments, the thickness of the second layer 233 in transistor 200 may be substantially equal to a total thickness of the second layer 132 and the third layer 133 in the embodiment disclosed above with respect to Figures 1A-1F. In other embodiments, the thickness of the second layer 233 in transistor 200 may be smaller or larger than a total thickness of the second layer 132 and the third layer 133 in the embodiment disclosed above with respect to Figures 1A-1F.

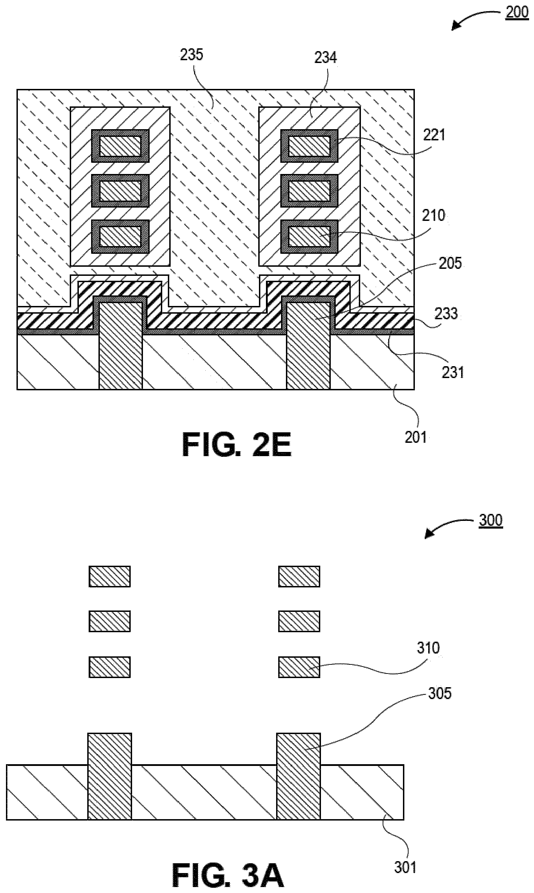

Referring now to Figure 2E, a cross-sectional illustration of the transistor device 200 after the gate stack is formed is shown, in accordance with an embodiment. In an embodiment, the gate stack may comprise a workfunction metal 234 and a fill metal 235. Suitable materials for the workfunction metal 234 and the fill metal 235 are described in greater detail above, and will not be repeated here in the interest of brevity. As shown, the spacing between the bottommost channel region 210 and the top of the sub-fin 205 provides sufficient room to completely surround the bottommost channel region 210 with the gate metals 234 and 235. Furthermore, it is to be appreciated that the workfunction metal 234 may be a conformal layer, and the workfunction metal 234 may be deposited over all exposed surfaces.

Referring now to Figures 3A-3E, a series of cross-sectional illustrations depicting a process for forming a transistor device 300 is shown, in accordance with an embodiment. In the illustrated embodiments, the transistor device 300 is formed with a gate dielectric last approach. That is, the insulative barrier layer is formed before the formation of the gate dielectric. As such, the ordering of the layers in transistor device 300 is different than the embodiments disclosed above.

Referring now to Figure 3A, a cross-sectional illustration of a transistor device 300 is shown, in accordance with an embodiment. In an embodiment, the transistor device 300 in Figure 3A may be substantially similar to the transistor device 100 illustrated in Figure 1A. For example, sub-fins 305 extend up through a substrate layer 301. Additionally, one or more channel regions 310 may be disposed over a top surface of the sub-fins 305. A spacing between the bottommost channel region 310 and the sub-fin 305 may be larger than a spacing between the channel regions 310.

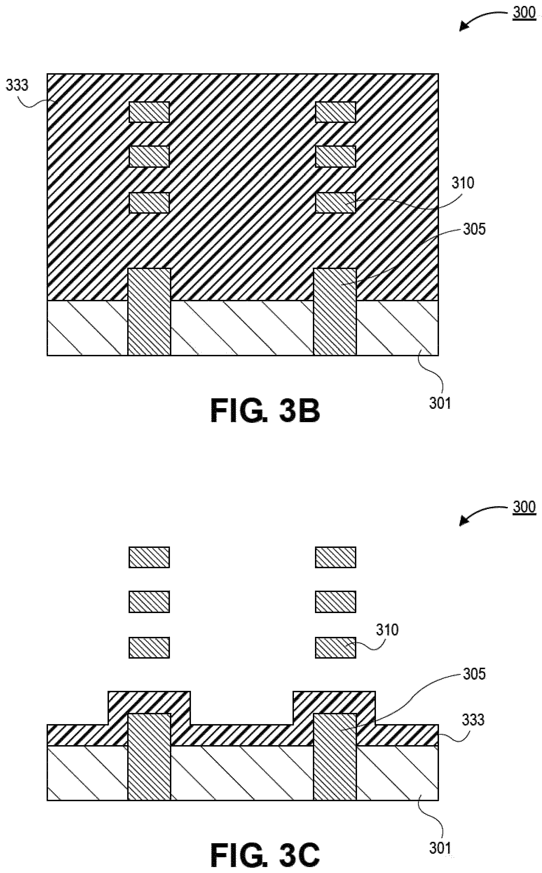

Referring now to Figure 3B, a cross-sectional illustration of the transistor device 300 after a first layer 333 is disposed over the surfaces is shown, in accordance with an embodiment. In an embodiment, the first layer 333 may be an insulating layer. For example, the first layer 333 may comprise silicon and oxygen (e.g., SiOx) or silicon and nitrogen (e.g., SiNx). In an embodiment, the first layer 333 is deposited with a blanket deposition process. The thickness of the first layer 333 may be sufficient to cover all of the channel regions 310. However, it is to be appreciated that in other embodiments one or more of the channel regions 310 may be above a top surface of the first layer 333.

Referring now to Figure 3C, a cross-sectional illustration of the transistor device 300 after the first layer 333 is recessed is shown, in accordance with an embodiment. In an embodiment, the first layer 333 may be recessed with a wet etching process. The wet etching process may be a timed etch. The recessing results in a top surface of the first layer 333 being below the bottommost channel region 310.

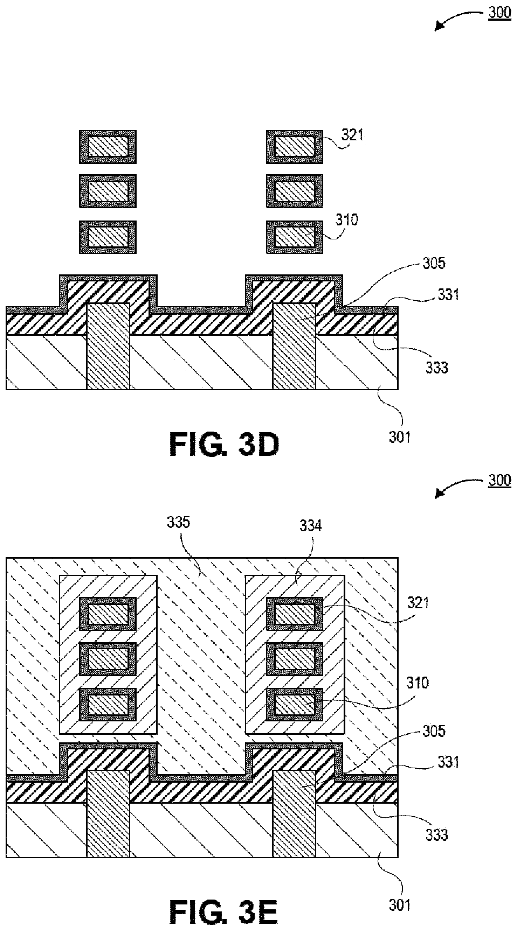

Referring now to Figure 3D, a cross-sectional illustration of the transistor device 300 after a gate dielectric 321 is disposed over the channel regions 310 is shown, in accordance with an embodiment. In an embodiment, the gate dielectric 321 may be a high-k dielectric, such as the high-k dielectric materials described in greater detail above. The gate dielectric 321 may be deposited with a conformal deposition process, such as an ALD process. In addition to forming the gate dielectric 321 around the channel regions 310, the deposition process may also result in a second layer 331 being disposed over the first layer 333. The second layer 331 may be substantially the same material as the gate dielectric 321, and the second layer 331 may have substantially the same thickness as the gate dielectric 321.

Referring now to Figure 3E, a cross-sectional illustration of the transistor device 300 after a gate stack is disposed around the channel regions 310 is shown, in accordance with an embodiment. In an embodiment, the gate stack may comprise a workfunction metal 334 and a fill metal 335. Suitable materials for the workfunction metal 334 and the fill metal 335 are described in greater detail above, and will not be repeated here in the interest of brevity. As shown, the spacing between the bottommost channel region 310 and the top of the sub-fin 305 provides sufficient room to completely surround the bottommost channel region 310 with the gate metals 334 and 335. Furthermore, it is to be appreciated that the workfunction metal 334 may be a conformal layer, and the workfunction metal 334 may be deposited over all exposed surfaces.

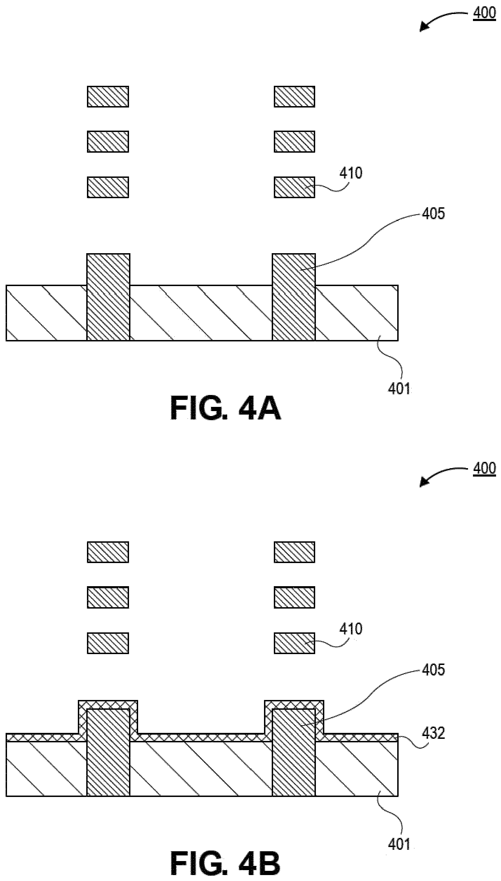

Referring now to Figures 4A-4G, a series of cross-sectional illustrations of a transistor device 400 is shown, in accordance with an embodiment. In an embodiment, the transistor device 400 is formed through the use of a self-assembled monolayer (SAM). The SAM allows for selective deposition of a barrier layer. As such, there is no need for lithography or other patterning processes.

Referring now to Figure 4A, a cross-sectional illustration of a transistor device 400 is shown, in accordance with an embodiment. In an embodiment, the transistor device 400 in Figure 4A may be substantially similar to the transistor device 100 illustrated in Figure 1A. For example, sub-fins 405 extend up through a substrate layer 401. Additionally, one or more channel regions 410 may be disposed over a top surface of the sub-fins 405. A spacing between the bottommost channel region 410 and the sub-fin 405 may be larger than a spacing between the channel regions 410.

Referring now to Figure 4B, a cross-sectional illustration of the transistor device 400 after a first layer 432 is disposed over the substrate layer 401 and the sub-fins 405 is shown, in accordance with an embodiment. The first layer 432 may be an insulating material. For example, the first layer 432 may comprise silicon and oxygen (e.g., SiOx) or silicon and nitrogen (e.g., SiNx). In an embodiment, the first layer 432 may be deposited with a blanket deposition process. The first layer 432 may then be recessed in order for a top surface of the first layer 432 to be below a bottom surface of a bottommost channel region 410.

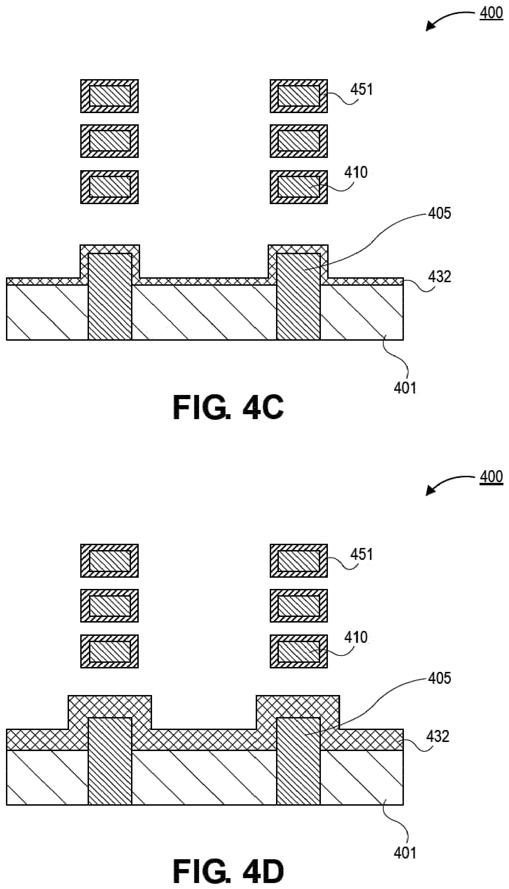

Referring now to Figure 4C, a cross-sectional illustration of the transistor device 400 after a SAM 451 is disposed around the channel regions 410 is shown, in accordance with an embodiment. In an embodiment, the SAM 451 may be selectively disposed over the channel regions 410. In an embodiment, the SAM 451 may be alkylsilane, though other SAM materials may also be used. The SAM 451 prevents growth of an oxide over the channel regions 410 in subsequent processing operations.

Referring now to Figure 4D, a cross-sectional illustration of the transistor device 400 after a thickness of the first layer 432 is increased is shown, in accordance with an embodiment. In an embodiment, the first layer 432 may be increased in thickness using a conformal deposition process, such as ALD. For example, a Si02 first layer 432 may be increased in thickness with an ALD process comprising SiCl₄ and H₂O, though other source gases may also be used in various embodiments. In the illustrated embodiment, the first layer 432 is increased in thickness, but it is to be appreciated that a second layer may be disposed over the first layer 432 in other embodiments. For example, the first layer 432 may comprise SiOx and the second layer may comprise SiNx.

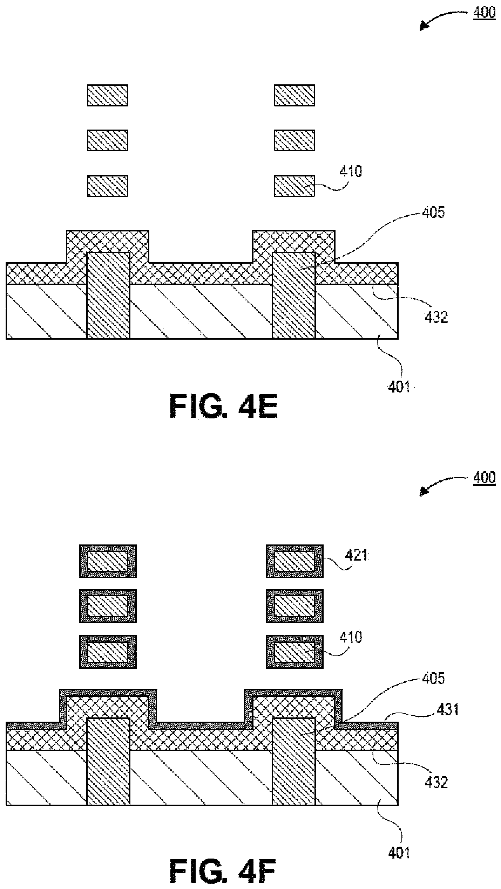

Referring now to Figure 4E, a cross-sectional illustration of the transistor device 400 after the SAM 451 is removed from the channel regions 410 is shown, in accordance with an embodiment. In an embodiment, the SAM 451 may be removed with an etching process or the like. In some embodiments, the SAM 451 may not be removed. In such embodiments, the SAM 451 may remain between the channel regions 410 and the subsequently formed gate dielectric.

Referring now to Figure 4F, a cross-sectional illustration of the transistor device 400 after a gate dielectric 421 is disposed over the channel regions 410 is shown, in accordance with an embodiment. In an embodiment, the gate dielectric 421 may be a high-k dielectric, such as the high-k dielectric materials described in greater detail above. The gate dielectric 421 may be deposited with a conformal deposition process, such as an ALD process. In addition to forming the gate dielectric 421 around the channel regions 410, the deposition process may also result in a second layer 431 being disposed over the first layer 432. The second layer 431 may be substantially the same material as the gate dielectric 421, and the second layer 431 may have substantially the same thickness as the gate dielectric 421.

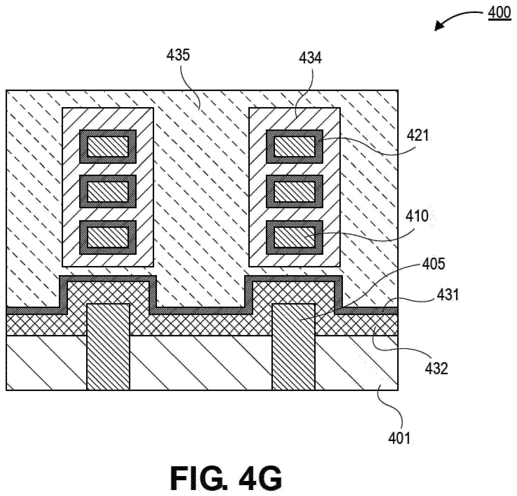

Referring now to Figure 4G, a cross-sectional illustration of the transistor device 400 after a gate stack is disposed around the channel regions 410 is shown, in accordance with an embodiment. In an embodiment, the gate stack may comprise a workfunction metal 434 and a fill metal 435. Suitable materials for the workfunction metal 434 and the fill metal 435 are described in greater detail above, and will not be repeated here in the interest of brevity. As shown, the spacing between the bottommost channel region 410 and the top of the sub-fin 405 provides sufficient room to completely surround the bottommost channel region 410 with the gate metals 434 and 435. Furthermore, it is to be appreciated that the workfunction metal 434 may be a conformal layer, and the workfunction metal 434 may be deposited over all exposed surfaces.

It is to be appreciated that the Figures and descriptions provided above use an idealized configuration of the layers and structures. That is, features (e.g., vertical sidewalls, sharp corners, flat surfaces, etc.) are simplified for the convenience of describing certain aspects of embodiments disclosed herein. However, it is to be appreciated that the illustrated features in Figures 1A-4G may have variations in an actual device. Some of those variations are illustrated in Figures 5 and 6, which illustrate the structure of the transistor device in a manner that more closely resembles what an actual device may look like.

Referring now to Figure 5, a cross-sectional illustration of a transistor device 500 is shown, in accordance with an embodiment. In an embodiment, the transistor device 500 comprises a base layer 502. The base layer 502 may be a semiconductor layer, or the like. In an embodiment, sub-fins 505 extend up from the base layer 502. As shown, the sub-fins may have sidewall surfaces 507 that are sloped. Additionally, a top of the sub-fins 505 may have rounded corners. In an embodiment, the sub-fins 505 extend up through a substrate layer 501. The substrate layer 501 may be an insulating layer, a polysilicon, or the like. In an embodiment, a top surface of the substrate layer 501 may be non-planar. For example, a peak 506 may be provided between pairs of sub-fins 505.

In an embodiment, channel regions 510 may be provided above the sub-fins 505. The channel regions 510 may have rounded corners in some embodiments. The bottommost channel region 510 may have a first spacing S₁ from the sub-fin 505, and the channel regions 510 may have a second spacing S₂ with each other. The second spacing S₂ may be smaller than the first spacing S₁. In an embodiment, a gate dielectric 521 is provided around each of the channel regions 510. A workfunction metal 534 may be provided around the gate dielectrics 521. The workfunction metal 534 may be conformally deposited and have rounded corners and non-vertical sidewalls. In an embodiment, a fill metal 535 may surround the workfunction metal 534.

In an embodiment, a series of layers are provided over the sub-fin 505 and the substrate layer 501. A first layer 531 may be provided in direct contact with the sub-fin 505 and the substrate layer 501. The first layer 531 may be the same material as the gate dielectric 521 in some embodiments. As shown, the first layer 531 is conformal and matches the topography of the underlying sub-fin 505 and substrate layer 501. A second layer 532 may be disposed over and in contact with the first layer 531. In an embodiment, the second layer 532 is a conformal layer as well. In an embodiment, the second layer 532 comprises a first insulating material, such as SiOx. In an embodiment, a third layer 533 is disposed over and in contact with the second layer 532. The third layer may be a conformal layer as well. In an embodiment, the third layer 532 comprises a second insulating material, such as SiNx.

Referring now to Figure 6, a cross-sectional illustration of a transistor device 600 is shown, in accordance with an additional embodiment. In an embodiment, the transistor device 600 may be substantially similar to the transistor device 500 in Figure 5, with the exception of a reduction in the number of barrier layers over the sub-fin 605 and the substrate layer 601. That is, the transistor device 600 may include a base layer 602 up from which the sub-fins 605 with non-vertical sidewalls 607 extend. The sub-fins 605 extend through a substrate layer 601 with a non-planar top surface (e.g., a peak 606 may be present). Channel regions 610 are surrounded by a gate dielectric 621 and a workfunction metal 634. A fill metal 635 may be disposed around the workfunction metal 634.

In an embodiment, a first layer 632 may be disposed over and in contact with the sub-fin 605 and the substrate layer 601. In an embodiment, the first layer 632 may be an insulating material. For example, the first layer 632 may comprise silicon and oxygen (e.g., SiOx) or silicon and nitrogen (e.g., SiNx). In an embodiment, the first layer 632 is a conformal layer and matches the underlying topography of the sub-fins 605 and the substrate layer 601. In an embodiment, a second layer 631 is provided over the first layer 632. The second layer 631 may be the same material as the gate dielectric 621. The second layer 631 may also be a conformal layer that matches the topography of the underlying first layer 632.

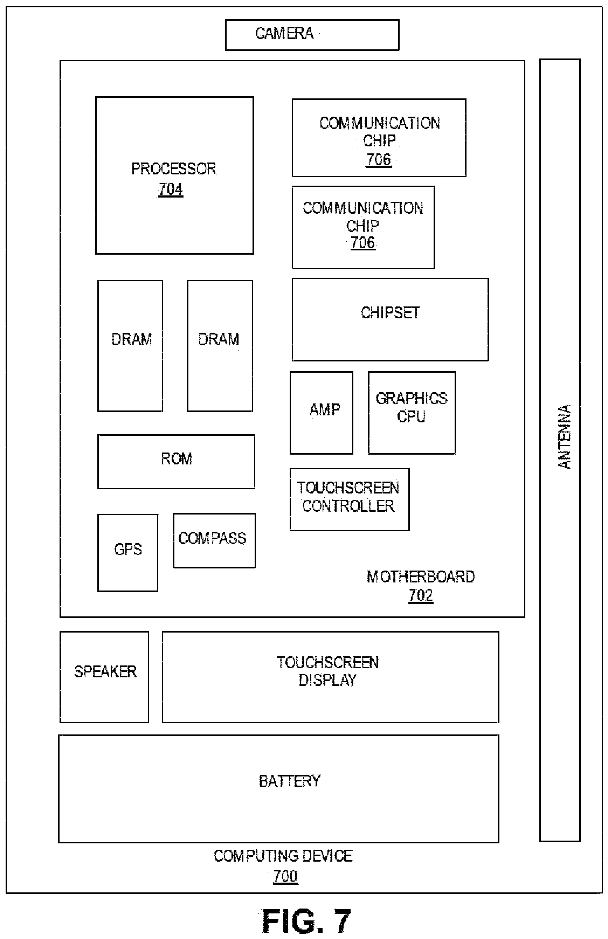

Figure 7 illustrates a computing device 700 in accordance with one implementation of an embodiment of the disclosure. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

Depending on its applications, computing device 700 may include other components that may or may not be physically and electrically coupled to the board 702. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In an embodiment, the integrated circuit die of the processor may comprise a transistor device with one or more insulating barrier layers between the channel region and a sub-fin, as described herein. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In an embodiment, the integrated circuit die of the communication chip may comprise a transistor device with one or more insulating barrier layers between the channel region and a sub-fin, as described herein.

In further implementations, another component housed within the computing device 700 may comprise a transistor device with one or more insulating barrier layers between the channel region and a sub-fin, as described herein.

In various implementations, the computing device 700 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 700 may be any other electronic device that processes data.

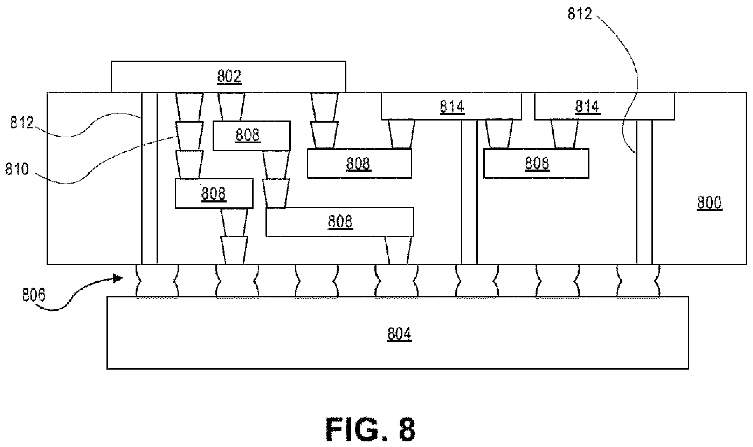

Figure 8 illustrates an interposer 800 that includes one or more embodiments of the disclosure. The interposer 800 is an intervening substrate used to bridge a first substrate 802 to a second substrate 804. The first substrate 802 may be, for instance, an integrated circuit die. The second substrate 804 may be, for instance, a memory module, a computer motherboard, or another integrated circuit die. In an embodiment, one of both of the first substrate 802 and the second substrate 804 may comprise a transistor device with one or more insulating barrier layers between the channel region and a sub-fin, in accordance with embodiments described herein. Generally, the purpose of an interposer 800 is to spread a connection to a wider pitch or to reroute a connection to a different connection. For example, an interposer 800 may couple an integrated circuit die to a ball grid array (BGA) 806 that can subsequently be coupled to the second substrate 804. In some embodiments, the first and second substrates 802/804 are attached to opposing sides of the interposer 800. In other embodiments, the first and second substrates 802/804 are attached to the same side of the interposer 800. And in further embodiments, three or more substrates are interconnected by way of the interposer 800.

The interposer 800 may be formed of an epoxy resin, a fiberglass-reinforced epoxy resin, a ceramic material, or a polymer material such as polyimide. In further implementations, the interposer 800 may be formed of alternate rigid or flexible materials that may include the same materials described above for use in a semiconductor substrate, such as silicon, germanium, and other group III-V and group IV materials.

The interposer 800 may include metal interconnects 808 and vias 810, including but not limited to through-silicon vias (TSVs) 812. The interposer 800 may further include embedded devices 814, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 800. In accordance with embodiments of the disclosure, apparatuses or processes disclosed herein may be used in the fabrication of interposer 800.

Thus, embodiments of the present disclosure may comprise a transistor device with one or more insulating barrier layers between the channel region and a sub-fin.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: a semiconductor device, comprising: a sub-fin, wherein the sub-fin comprises a semiconductor material; a channel above the sub-fin, wherein the channel is physically detached from the sub-fin; a first layer over the sub-fin; and a second layer over the first layer, wherein the second layer is different than the first layer.

Example 2: the semiconductor device of Example 1, wherein the first layer comprises silicon and oxygen.

Example 3: the semiconductor device of Example 1 or Example 2, wherein the second layer comprises silicon and nitrogen.

Example 4: the semiconductor device of Examples 1-3, wherein the channel is a nanosheet or a nanowire.

Example 5: the semiconductor device of Examples 1-4, further comprising: a gate dielectric surrounding a perimeter of the channel.

Example 6: the semiconductor device of Example 5, further comprising: a third layer over the sub-fin, wherein the third layer and the gate dielectric comprise the same material.

Example 7: the semiconductor device of Example 6, wherein the third layer is over the second layer.

Example 8: the semiconductor device of Example 6, wherein the third layer is between the sub-fin and the first layer.

Example 9: the semiconductor device of Examples 1-9, further comprising: a plurality of channels above the sub-fin.

Example 10: the semiconductor device of Example 9, wherein a spacing between the plurality of channels has a first distance, and wherein a spacing between the sub-fin and a bottommost channel has a second distance, wherein the second distance is greater than the first distance.

Example 11: the semiconductor device, comprising: a sub-fin, wherein the sub-fin comprises a semiconductor material; a channel above the sub-fin, wherein the channel is physically spaced away from the sub-fin; a layer over the sub-fin between the channel and the sub-fin, wherein the layer is an insulating material; a gate dielectric around a perimeter of the channel; and a gate electrode surrounding the gate dielectric.

Example 12: the semiconductor device of Example 11, wherein the layer comprises silicon and oxygen.

Example 13: the semiconductor device of Example 11, wherein the layer comprises silicon and nitrogen.

Example 14: the semiconductor device of Examples 11-13, further comprising: a self-assembled monolayer between the channel and the gate dielectric.

Example 15: the semiconductor device of Examples 11-14, further comprising: a plurality of channels above the sub-fin.

Example 16: the semiconductor device of Example 15, wherein a spacing between channels is a first distance, and a spacing between a bottommost channel and the sub-fin is a second distance, wherein the second distance is greater than the first distance.

Example 17: the semiconductor device of Examples 11-16, further comprising: a second layer over the layer, wherein the second layer and the gate dielectric comprise the same material.

Example 18: the semiconductor device of Examples 11-17, wherein channel is a nanowire or nanosheet.

Example 19: the semiconductor device of Examples 11-17, wherein a thickness of the layer is greater than a thickness of the gate dielectric.

Example 20: a method of forming a semiconductor device, comprising: providing a sub-fin with a channel above the sub-fin; disposing a first layer over the sub-fin and around the channel; recessing the first layer so that a top surface of the first layer is below the channel; and selectively growing a second layer on the first layer.

Example 21: the method of Example 20, wherein a gate dielectric is formed around the channel before formation of the first layer.

Example 22: the method of Example 21, wherein selectively growing the second layer comprises a plasma treatment to the first layer and the gate dielectric.

Example 23: the method of Examples 20-22, wherein the first layer comprises silicon and oxygen, and wherein the second layer comprises silicon and nitrogen.

Example 24: an electronic system, comprising: a board; a package substrate coupled to the board; and a die coupled to the package substrate, wherein the die comprises: a sub-fin, wherein the sub-fin comprises a semiconductor material; a channel above the sub-fin, wherein the channel is physically detached from the sub-fin; a first layer over the sub-fin; and a second layer over the first layer, wherein the second layer is different than the first layer.

Example 25: the electronic system of Example 24, wherein the first layer comprises silicon and oxygen, and wherein the second layer comprises silicon and nitrogen.

## Claims

1. A semiconductor device, comprising:
a sub-fin, wherein the sub-fin comprises a semiconductor material;
a channel above the sub-fin, wherein the channel is physically detached from the sub-fin;
a first layer over the sub-fin, wherein the first layer comprises a first material composition; and
a second layer over the first layer, wherein the second layer comprises a second material composition that is different than the first material composition.

2. The semiconductor device of claim 1, wherein the first layer comprises silicon and oxygen.

3. The semiconductor device of claim 1 or 2, wherein the second layer comprises silicon and nitrogen.

4. The semiconductor device of claim 1, 2 or 3, wherein the channel is a nanosheet or a nanowire.

5. The semiconductor device of claim 1, 2, 3 or 4, further comprising:
a gate dielectric surrounding a perimeter of the channel.

6. The semiconductor device of claim 5, further comprising:
a third layer over the sub-fin, wherein the third layer and the gate dielectric comprise the same material.

7. The semiconductor device of claim 6, wherein the third layer is over the second layer.

8. The semiconductor device of claim 6, wherein the third layer is between the sub-fin and the first layer.

9. The semiconductor device of claim 1, 2, 3, 4, 5, 6, 7 or 8, further comprising:
a plurality of channels above the sub-fin.

10. The semiconductor device of claim 9, wherein a spacing between the plurality of channels has a first distance, and wherein a spacing between the sub-fin and a bottommost channel has a second distance, wherein the second distance is greater than the first distance.

11. A method of forming a semiconductor device, comprising:
providing a sub-fin with a channel above the sub-fin;
disposing a first layer over the sub-fin and around the channel;
recessing the first layer so that a top surface of the first layer is below the channel; and
selectively growing a second layer on the first layer.

12. The method of claim 11, wherein a gate dielectric is formed around the channel before formation of the first layer.

13. The method of claim 12, wherein selectively growing the second layer comprises a plasma treatment to the first layer and the gate dielectric.

14. The method of claim 11, 12 or 13, wherein the first layer comprises silicon and oxygen, and wherein the second layer comprises silicon and nitrogen.

15. An electronic system, comprising:
a board;
a package substrate coupled to the board; and
a die coupled to the package substrate, wherein the die comprises:
a sub-fin, wherein the sub-fin comprises a semiconductor material;
a channel above the sub-fin, wherein the channel is physically detached from the sub-fin;
a first layer over the sub-fin; and
a second layer over the first layer, wherein the second layer is different than the first layer.
